# EUROPEAN PATENT SPECIFICATION

(11) **EP 4 287 511 B1**
(45) Date of publication and mention of the grant of the patent: **09.09.2026**
(21) Application number: 22745036.8
(22) Date of filing: 11.01.2022
(51) Int. Cl.: H03K 17/96

(54) **TOUCH PANEL SWITCH SYSTEM AND STEERING WHEEL**
BERÜHRUNGSBILDSCHIRMSCHALTERSYSTEM UND LENKRAD
SYSTÈME DE COMMUTATION À PANNEAU TACTILE ET VOLANT DE DIRECTION

(30) Priority: 27.01.2021 CN 202120232145 U
(43) Date of publication of application: 06.12.2023
(73) Proprietor: Autoliv Development AB, 44783 Vargarda (SE)
(72) Inventor: XU, Linlin, Shanghai 201807 (CN); JIANG, Zhiyong, Shanghai 201807 (CN); ZHENG, Wenjian, Shanghai 201807 (CN)
(74) Representative: Novagraaf International SA
(86) International application number: PCT/CN2022/071332
(87) International publication number: WO 2022/161158

(56) References cited:
- CN-A- 112 208 621
- CN-U- 210 776 591
- CN-U- 211 995 446
- CN-U- 214 177 292
- US-A1- 2020 039 559

## Description

### TECHNICAL FIELD

The present invention relates to the technical field of steering wheels of vehicles, and particularly to a touch panel switch system and a steering wheel.

### BACKGROUND

Existing panel switches are typically classified into three types. One type of panel switch is a touch switch that provides passive feedback, and has a certain pressing stroke. Panel switches of this type have an excessively soft tactile feel, require a large trigger stroke, and use a microswitch that has a large thickness and occupies a large space. In addition, in order to affect a stroke for a large panel, the structure of a balancing lever is further required.

Another type of panel switch employs active tactile feedback of a solenoid valve. Panel switches of this type have the disadvantage that the tactile feel is not adjustable.

Yet another type of panel switch is a panel switch without a stroke. Panel switches of this type have an excessively hard tactile feel, and provide no trigger feedback which results in a poor user experience.

Therefore, there is a need to design a touch panel switch system and a steering wheel achieving both touch elasticity and stiffness, requiring a small trigger stroke, occupying a small space, and providing adjustable tactile feel.

Examples of relevant prior art can be found in CN 214 177 292 U, CN 211 995 446 U, CN 112 208 621 A, CN 210 776 591 U, as well as US 2020/039559 A1.

### SUMMARY

The invention is defined by the independent claim 1. Further embodiments of the invention are defined by the dependent claims.

An objective of the present invention is to overcome the disadvantages in the prior art, and provide a touch panel switch system and a steering wheel achieving both touch elasticity and stiffness, requiring a small trigger stroke, occupying a small space, and providing adjustable tactile feel.

Provided in the technical solution of the present invention is a touch panel switch system, comprising an upper assembly, a lower assembly, and a suspension assembly.

The upper assembly comprises a top cover and an inner support, and the top cover and the inner support are fixedly connected to each other.

The lower assembly comprises a housing and a bottom cover, the top cover and the housing are movably connected to each other, and the housing is fixedly connected to the bottom cover.

The suspension assembly is connected between the upper assembly and the lower assembly, the suspension assembly effects a trigger stroke in a Z direction, and the trigger stroke is at micron scale.

Further, the lower assembly further comprises a printed circuit board provided between the inner support and the bottom cover.

A micron-scale pressure sensor is mounted on the printed circuit board.

A mounting column extends downwards from the inner support, and is used to press the micron-scale pressure sensor.

Further, the touch panel switch system further comprises a pretensioner mounted on the mounting column and in contact with the micron-scale pressure sensor. The pretensioner provides the micron-scale pressure sensor with an initial value, and a trigger threshold is set for the micron-scale pressure sensor.

A functional component of the touch panel switch system is not triggered when the micron-scale pressure sensor is subjected to a force less than the initial value,

The functional component is triggered when the micron-scale pressure sensor is subjected to a force exceeding the trigger threshold.

Further, the suspension assembly is mounted between the inner support and the housing.

Further, the suspension assembly comprises an elastic member and an elastic jaw. The elastic jaw extends downwards from a lower surface of the inner support, and the elastic member is connected between the elastic jaw and the housing or the printed circuit board.

Further, the elastic jaw comprises a plurality of barbs spaced apart from each other.

Further, the elastic jaw comprises an inverted mushroom head structure, and the shape of the elastic member matches the shape of the mushroom head structure.

Further, the suspension assembly comprises a first elastic holding member, a second elastic holding member, and an elastic member. The first elastic holding member is connected to the inner support, the second elastic holding member is connected to the housing or the printed circuit board, and the elastic member is connected between the first elastic holding member and the second elastic holding member.

Further, the elastic member is made of solid rubber or hollow rubber.

Also provided in the present invention is a steering wheel, comprising the touch panel switch system described above.

The above technical solution can achieve the following beneficial effects:

In the present invention, the suspension assembly is provided, and the suspension assembly enables the micron-scale trigger stroke in the Z direction to be effected between the upper assembly and the lower assembly. The stroke can be converted into an input of a force value, so as to determine whether a threshold set by the system is reached. In the present invention, the touch panel switch system achieves both touch elasticity and rigidity, so that when the touch panel switch system is triggered, a certain trigger feedback is provided. In this manner, triggering of a corresponding function can be achieved by means of a very small trigger stroke, thereby improving the user experience. In addition, the touch panel switch system of the present invention occupies a small space, and has a high integration level.

### BRIEF DESCRIPTION OF THE DRAWINGS

The disclosure of the present invention will become better understood with reference to the accompanying drawings. It should be understood that these drawings are for illustrative purposes only and are not intended to limit the scope of protection of the present invention. In the drawings:
FIG. 1 is a schematic view of a touch panel switch system mounted on a steering wheel according to an embodiment of the present invention;
FIG. 2 is a top view of a touch panel switch system according to an embodiment of the present invention;
FIG. 3 is a front view of a touch panel switch system according to an embodiment of the present invention;
FIG. 4 is a partial cross sectional view of a touch panel switch system according to Embodiment 1 of the present invention;
FIG. 5 is a schematic view of an inner support of the touch panel switch system according to Embodiment 1 of the present invention;
FIG. 6 is a longitudinal cross sectional view of a touch panel switch system according to Embodiment 2 of the present invention;
FIG. 7 is a schematic view of an inner support of the touch panel switch system according to Embodiment 2 of the present invention;
FIG. 8 is a longitudinal cross sectional view of a touch panel switch system according to Embodiment 3 of the present invention; and
FIG. 9 is a schematic view of an inner support of the touch panel switch system according to Embodiment 3 of the present invention.

### Reference Numerals:

Touch panel switch system 100
upper assembly 1: top cover 11, inner support 12, touch conductive film 13, light guide plate 14, motor 15, mounting column 121, micron-scale pressure sensor 122, and pretensioner 123;
lower assembly 2: housing 21, bottom cover 22, printed circuit board 23, and hook 221; and
suspension assembly 3: elastic member 31, elastic jaw 34, first elastic holding member 35, second elastic holding member 36, barb 341, and mushroom head structure 342.

### DETAILED DESCRIPTION

Specific embodiments of the present invention are described further below with reference to the accompanying drawings.

It may be easily understood that those of ordinary skills in the art may propose a plurality of interchangeable structural modes and implementation methods according to the technical solutions of the present invention without changing the essential spirit of the present invention. Therefore, the following specific embodiments and the accompanying drawings are merely exemplary description of the technical solutions of the present invention, and should not be regarded as the whole of the present invention or regarded as limitations to the technical solutions of the present invention.

The positional terms of up, down, left, right, before, behind, front, back, top, bottom, etc. which are referred to or possibly referred to in this specification are defined with respect to the configurations shown in the drawings, and they are relative concepts; therefore, they may possibly change correspondingly according to different positions thereof and different use states. Therefore, these or other positional terms should not be construed as restrictive terms.

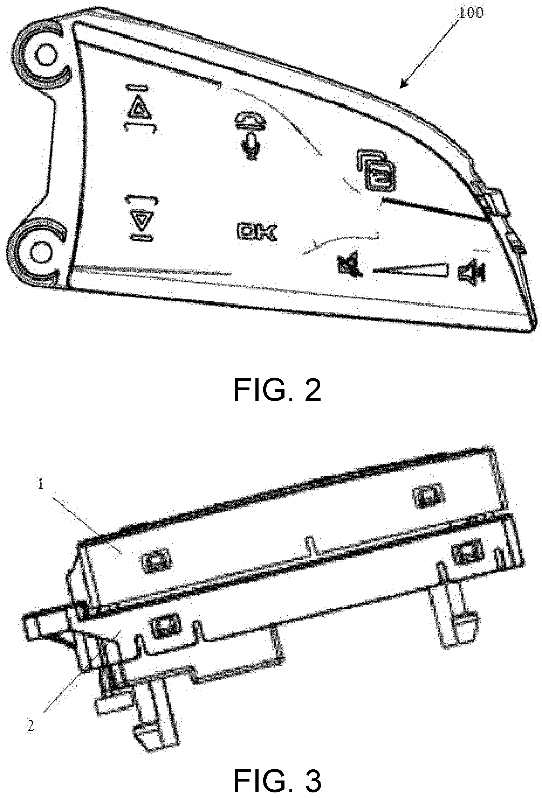

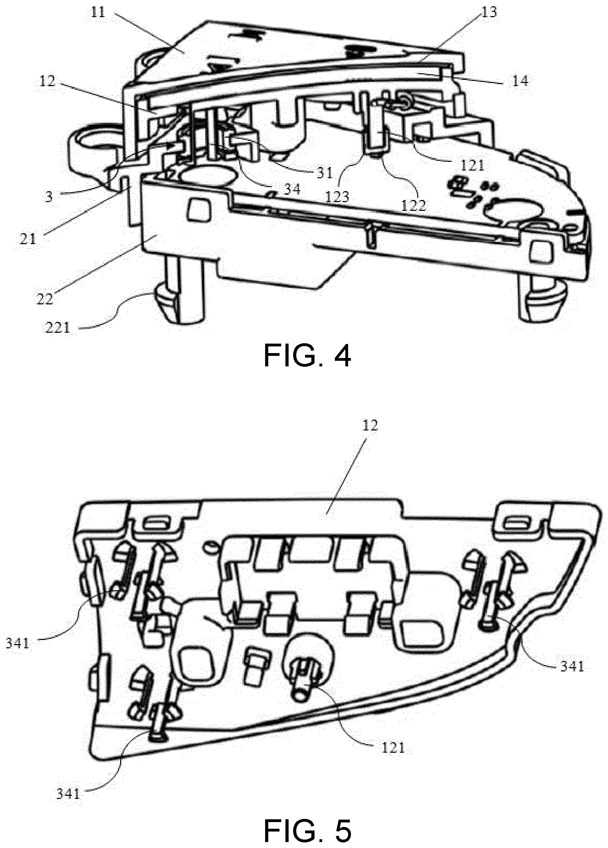

In some embodiments of the present invention, as shown in FIGs. 3 and 4, a touch panel switch system 100 includes an upper assembly 1, a lower assembly 2, and a suspension assembly 3.

The upper assembly 1 includes a top cover 11 and an inner support 12, and the top cover 11 and the inner support 12 are fixedly connected to each other.

The lower assembly 2 includes a housing 21 and a bottom cover 22. The top cover 11 and the housing 21 are movably connected to each other. The housing 21 is fixedly connected to the bottom cover 22.

The suspension assembly 3 is connected between the upper assembly 1 and the lower assembly 2. The suspension assembly 3 effects a trigger stroke in a Z direction. The trigger stroke is at micron scale.

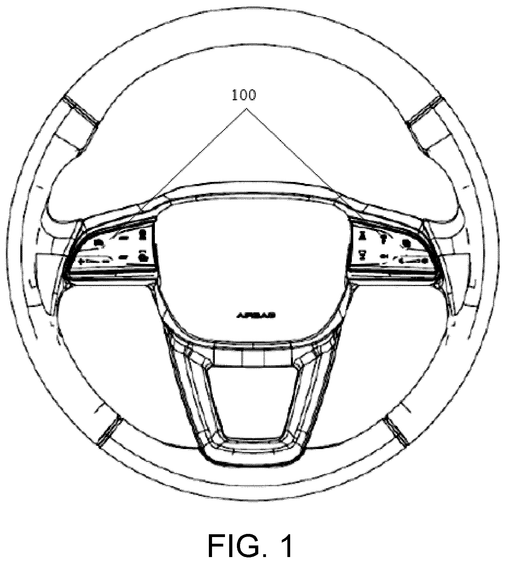

Specifically, as shown in FIG. 1, the touch panel switch system 100 is mounted on a left side of a steering wheel of a vehicle, so that a user can operate the same easily.

As shown in FIG. 2, a plurality of functional components are integrated into the touch panel switch system 100. Touching different keys can trigger different functional components. For example: adjustment of the cruising speed, the following distance, and the limit speed related to autonomous driving, and control of a multimedia system.

As shown in FIG. 3, the touch panel switch system 100 includes the upper assembly 1 and the lower assembly 2. The functional components of the touch panel switch system 100 are mounted in a cavity between the upper assembly 1 and the lower assembly 2. The lower assembly 2 is connected to a body of the steering wheel.

As shown in FIG. 4, the upper assembly 1 includes the top cover 11 and the inner support 12, and the top cover 11 and the inner support 12 are fixedly connected to each other. The top cover 11 is the uppermost cover of the touch panel switch system 100, and an upper surface of the top cover 11 is provided with a plurality of function keys. A touch conductive film 13 and a light guide plate 14 are mounted between the top cover 11 and the inner support 12. The touch conductive film 13 is mounted on the top cover 11 (via bonding using an optical clear adhesive or via high temperature attachment). The inner support 12 is used to support and mount the light guide plate 14. When a user touches the function key on the top cover 11, the touch conductive film 13 receives a pressing signal for triggering a corresponding functional component.

The lower assembly 2 includes the housing 21 and the bottom cover 22. The top cover 11 and the housing 21 are movably connected to each other in the Z direction. The housing 21 is fixedly connected to the bottom cover 22. A hook 221 extends downwards from the bottom cover 22, and is used to be connected to a main body of the steering wheel.

The "Z" direction in the present invention refers to an up-down direction of the steering wheel, i.e., an up-down direction in FIG. 4.

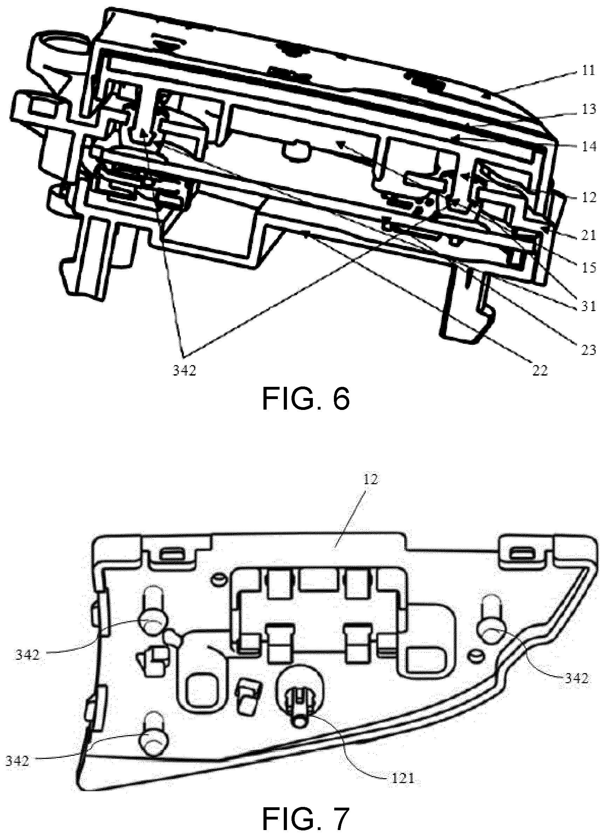

Since the suspension assembly 3 is connected between the upper assembly 1 and the lower assembly 2, the suspension assembly 3 effects a trigger stroke in the Z direction. When the user presses the function key on the top cover 11, the upper assembly 1 generates a trigger stroke in the Z direction relative to the lower assembly 2. The user cannot sense the micron-scale trigger stroke. Vibration of a motor 15 (referring to FIG. 6) drives the top cover 11 to produce a sense of vibration, and the user senses a trigger feedback. In the present invention, since the trigger stroke is at micron scale, the touch panel switch system achieves both touch elasticity and stiffness. Therefore, when the touch panel switch system is triggered, the stroke can be converted into an input of a force value, so as to determine whether a threshold set by the system is reached. When the set threshold is exceeded, a feedback element (e.g., the motor 15 generates vibration) applies a certain trigger feedback, which can be sensed by the user, to the top cover 11. In this manner, triggering of a corresponding function can be achieved by means of a very small trigger stroke, thereby improving the user experience. In addition, the touch panel switch system of the present invention occupies a small space, and has a high integration level.

In some embodiments of the present invention, as shown in FIGs. 4 and 5, the lower assembly 2 further includes a printed circuit board 23 provided between the inner support 12 and the bottom cover 22.

A micron-scale pressure sensor 122 is mounted on the printed circuit board 23.

A mounting column 121 extends downwards from the inner support 12, and is used to press the micron-scale pressure sensor 122.

Specifically, the micron-scale pressure sensor 122 is surface-mounted and soldered on the printed circuit board 23.

When the user presses the function key on the top cover 11, the touch conductive film 13 receives a pressing signal. The upper assembly 1 generates a trigger stroke in the Z direction. The mounting column 121 drives the micron-scale pressure sensor 122 downwards. A pressing force is generated between the micron-scale pressure sensor 122 and the printed circuit board 23. The micron-scale pressure sensor 122 detects a force value of the pressing force. When the force value of the pressing force is greater than a set force value, the micron-scale pressure sensor 122 transmits a signal to the printed circuit board 23. The printed circuit board 23 controls a corresponding functional component to be activated.

The suspension assembly 3 is suspended relative to the printed circuit board 23, so that the suspension assembly 3 does not touch or interfere with the printed circuit board 23 when the top cover 11 is pressed.

In some embodiments of the present invention, as shown in FIG. 4, a pretensioner 123 is further included. The micron-scale pressure sensor 122 is connected to the mounting column 121 by means of the pretensioner 123. The pretensioner 123 provides the micron-scale pressure sensor 122 with an initial value. A trigger threshold is set for the micron-scale pressure sensor 122.

A functional component of the touch panel switch system is not triggered when the micron-scale pressure sensor 122 is subjected to a force less than the initial value.

The functional component is triggered when the micron-scale pressure sensor 122 is subjected to a force exceeding the trigger threshold.

The pretensioner 123 may be an elastomer made of rubber. The pretensioner 123 is bowl-like, and sleeves on a bottom end of the mounting column 121. The micron-scale pressure sensor 122 is mounted at a bottom end of the pretensioner 123. The pretensioner 123 is compressed, and applies an initial force to the micron-scale pressure sensor 122, so that the micron-scale pressure sensor 122 has an initial value.

The micron-scale pressure sensor 122 is a sensor of extremely high precision, and can convert a micron-scale stroke into sensing of a force value, so as to replace a passive feedback of a conventional mechanical switch. The size of the micron-scale pressure sensor 122 is extremely small (the thickness of 0.6 mm), and compared with a microswitch, the micron-scale pressure sensor can reduce the thickness of the switch. In addition, a balancing sensing lever structure for triggering a microswitch is replaced. Compared with a microswitch of a fixed pressing force, the trigger threshold of the micron-scale pressure sensor 12 can be customized by means of software. That is, the trigger threshold can be readjusted without changing the structure or hardware. Setting of the trigger threshold can also prevent an accidental operation.

In some embodiments of the present invention, as shown in FIG. 4, the suspension assembly 3 is mounted between the inner support 12 and the housing 21.

When the upper assembly 1 is pressed, the inner support 12 generates a trigger stroke in the Z direction relative to the housing 21 by means of the suspension assembly 3.

### Embodiment 1:

As shown in FIGs. 4 and 5, the suspension assembly 3 includes an elastic member 31 and an elastic jaw 34. The elastic jaw 34 extends downwards from a lower surface of the inner support 12. The elastic member 31 is connected between the elastic jaw 34 and the housing 21.

Further, the elastic jaw 34 includes a plurality of barbs 341 spaced apart from each other.

Specifically, as shown in FIG. 5, three barbs 341 extend downwards from the inner support 12. The barb 341 may be formed integrally with the inner support 12, and is made of hard plastic. The barb 341 is elastically deformable to a certain degree.

The elastic member 31 is a circular ring made of rubber. An inner ring of the elastic member 31 sleeves on the outside the three barbs 341. Bottom ends of the barbs 341 restrain the elastic member 31. An outer ring of the elastic member 31 is still mated with a mounting hole on the housing 21.

A suspended connection between the upper assembly 1 and the lower assembly 2 is achieved by means of the elastic member 31 and the barbs 341. That is, a certain trigger stroke is effected in the Z direction.

In Embodiment 1, the elastic barb 341 absorbs a portion of deformation of the elastic member 31 in the Z direction. However, the barb 341 is elastic, so that the suspension assembly 3 achieves both elasticity and rigidity.

The rigidity of the suspension assembly 3 can be achieved by adjusting the stiffness of the rubber. That is, the stiffness of the rubber is increased or decreased to adjust the rigidity.

The rigidity may also be adjusted by adjusting the overlap amount of the barb 341, or the rigidity of the entire suspension assembly 3 is adjusted by adjusting the elasticity or stiffness of the barb 341.

In this embodiment, three suspension assemblies 3 are provided. Optionally, a different number of suspension assemblies 3 may be provided.

### Embodiment 2:

As shown in FIGs. 6 and 7, the elastic jaw 34 includes an inverted mushroom head structure 342, and the shape of the elastic member 31 matches the shape of the mushroom head structure 342.

Specifically, the mushroom head structure 342 also extends downwards from the inner support 12. It is different from Embodiment 2 that one suspension assembly 3 includes only one mushroom head structure 342. The shape of the elastic member 31 matches the shape of the mushroom head structure 342. The elastic member 31 is a rubber sleeve, and a middle portion thereof is hollow. The bottom of the mushroom head structure 342 is completely enclosed in the center of the elastic member 31. The exterior of the elastic member 31 is also in the shape of a mushroom head, and an outer wall thereof still fits the housing 21.

The elastic member 31 achieves an elastic connection between the inner support 12 and the housing 21, and the rigidity of the suspension assembly 3 can be adjusted by adjusting the stiffness of the rubber.

The elasticity can also be increased by increasing the thickness of a solid portion of the elastic member 31. Alternatively, the tactile feel is adjusted by changing the shape of the hollow portion of the elastic member 31, i.e., the depth and width of the hollow.

### Embodiment 3:

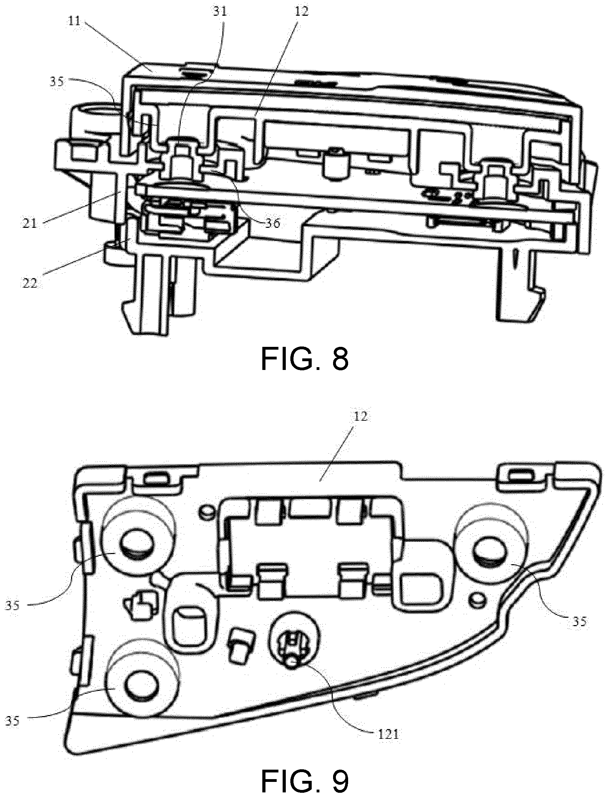

As shown in FIGs. 8 and 9, the suspension assembly 3 includes a first elastic holding member 35, a second elastic holding member 36, and an elastic member 31. The first elastic holding member 35 is fixedly connected to the inner support 12. The second elastic holding member 36 is connected to the housing 21. The elastic member 31 is connected between the first elastic holding member 35 and the second elastic holding member 36.

Specifically, the inner support 12 and the housing 21 are made of hard plastic. The first elastic holding member 35 is formed integrally with the inner support 12. The second elastic holding member 36 is formed integrally with the housing 21. The first elastic holding member 35 and the second elastic holding member 36 are elastic to a certain degree.

As shown in FIG. 9, the first elastic holding member 35 is a hollow ring structure. The second elastic holding member 36 is also a similar hollow ring structure.

As shown in FIG. 8, the elastic member 31 is made of rubber. An outer wall of the elastic member 31 is provided with two circular recesses respectively engaging with the first elastic holding member 35 and the second elastic holding member 36.

Compared with the preceding two embodiments, the suspension assembly 3 in Embodiment 3 has higher elasticity, a larger trigger stroke, and a softer tactile feel.

Further, the elastic member 31 is made of hollow rubber. The rigidity can be adjusted by adding a hard material to a cavity of the elastic member 31.

Alternatively, the elastic member 31 may also be made of solid rubber.

The rigidity and elasticity of the suspension assembly 3 may also be adjusted by adjusting the shape and size of the elastic member 31.

### Embodiment 4:

As shown in FIG. 1, a steering wheel includes any touch panel switch system 100 described above. Right and left sides of the steering wheel are each provided with one touch panel switch system 100. The top cover 11 of the touch panel switch system 100 is an integral large touch panel. Avery small trigger stroke is achieved by means of a micron-scale trigger stroke. That is, activation of a corresponding function can be triggered, and meanwhile a certain trigger feedback is maintained, thereby providing a user with a better experience. In addition, compared with a conventional system in which a microswitch or conductive rubber is provided as a switch, the present invention occupies a smaller space, has higher precision, and the trigger stroke and the feedback force value thereof can be adjusted or customized.

The above description is merely illustrative of the principles and preferred examples of the present invention.

## Claims

1. A touch panel switch system comprising an upper assembly (1), a lower assembly (2), and a suspension assembly (3);
the upper assembly (1) comprising a top cover (11) and an inner support (12), the top cover (11) and the inner support (12) being fixedly connected to each other;
the lower assembly (2) comprising a housing (21) and a bottom cover (22), the top cover (11) and the housing (21) being movably connected to each other, the housing (21) being fixedly connected to the bottom cover (22); and
the suspension assembly (3) being connected between the upper assembly (1) and the lower assembly (2), the suspension assembly (3) effecting a trigger stroke in a Z direction, and the trigger stroke being at micron scale,
**characterized in that** the lower assembly (2) further comprises a printed circuit board (23) provided between the inner support (12) and the bottom cover (22); a micron-scale pressure sensor (122) being mounted on the printed circuit board (23); and
a mounting column (121) extending downwards from the inner support (12), and being used to press the micron-scale pressure sensor (122),
and **in that** the touch panel switch system further comprises a pretensioner (123) mounted on the mounting column (121) and in contact with the micron-scale pressure sensor (122), the pretensioner (123) providing the micron-scale pressure sensor (122) with an initial value, a trigger threshold being set for the micron-scale pressure sensor (122).

2. The touch panel switch system according to claim 1, wherein:
a functional component of the touch panel switch system being not triggered when the micron-scale pressure sensor (122) is subjected to a force less than the initial value; and
the functional component being triggered when the micron-scale pressure sensor (122) is subjected to a force exceeding the trigger threshold.

3. The touch panel switch system according to claim 1, wherein the suspension assembly (3) is mounted between the inner support (12) and the housing (21).

4. The touch panel switch system according to claim 3, wherein the suspension assembly (3) comprises an elastic member (31) and an elastic jaw (34), the elastic jaw (34) extending downwards from a lower surface of the inner support (12), and the elastic member (31) being connected between the elastic jaw (34) and the housing (21).

5. The touch panel switch system according to claim 4, wherein the elastic jaw (34) comprises a plurality of barbs (341) spaced apart from each other.

6. The touch panel switch system according to claim 4, wherein the elastic jaw (34) comprises an inverted mushroom head structure (342), and the shape of the elastic member (31) matches the shape of the mushroom head structure (342).

7. The touch panel switch system according to claim 3, wherein the suspension assembly (3) comprises a first elastic holding member (35), a second elastic holding member (36), and an elastic member (31), the first elastic holding member (35) being connected to the inner support (12), the second elastic holding member (36) being connected to the housing (21), and the elastic member (31) being connected between the first elastic holding member (35) and the second elastic holding member (36).

8. The touch panel switch system according to claim 7, wherein the elastic member (31) is made of solid rubber or hollow rubber.

9. A steering wheel, **characterized by** comprising the touch panel switch system (100) according to any one of claims 1-8.

## Patentansprüche

1. Schaltersystem eines Berührungsbedienungsfelds, umfassend eine obere Anordnung (1), eine untere Anordnung (2) und eine Aufhängungsanordnung (3);
die obere Anordnung (1) umfassend eine Oberabdeckung (11) und eine innere Stütze (12), wobei die Oberabdeckung (11) und die innere Stütze (12) fest miteinander verbunden sind;
die untere Anordnung (2) umfassend ein Gehäuse (21) und eine Bodenabdeckung (22), wobei die Oberabdeckung (11) und das Gehäuse (21) beweglich miteinander verbunden sind, wobei das Gehäuse (21) fest mit der Bodenabdeckung (22) verbunden ist; und
wobei die Aufhängungsanordnung (3) zwischen der oberen Anordnung (1) und der unteren Anordnung (2) verbunden ist, wobei die Aufhängungsanordnung (3) einen Auslösehub in einer Z-Richtung bewirkt und der Auslösehub in einem Mikrometerumfang liegt,
**dadurch gekennzeichnet, dass** die untere Anordnung (2) ferner eine gedruckte Leiterplatte (23) umfasst, die zwischen der inneren Stütze (12) und der Bodenabdeckung (22) bereitgestellt ist; ein Sensor (122) von Druck im Mikrometerumfang auf der gedruckten Leiterplatte (23) montiert ist; und
eine Montagesäule (121) sich von der inneren Stütze (12) nach unten erstreckt und verwendet wird, um den Sensor (122) von Druck im Mikrometerumfang zu drücken,
und dadurch, dass das Schaltersystem des Berührungsbedienungsfelds ferner einen Vorspanner (123) umfasst, der auf der Montagesäule (121) und in Kontakt mit dem Sensor (122) von Druck im Mikrometerumfang montiert ist, wobei der Vorspanner (123) den Sensor (122) von Druck im Mikrometerumfang mit einem Anfangswert versieht, wobei eine Auslöseschwelle für den Sensor (122) von Druck im Mikrometerumfang eingestellt wird.

2. Schaltersystem des Berührungsbedienungsfelds nach Anspruch 1, wobei:
eine Funktionskomponente des Schaltersystems des Berührungsbedienungsfelds nicht ausgelöst wird, wenn der Sensor (122) von Druck im Mikrometerumfang einer Kraft ausgesetzt ist, die geringer als der Anfangswert ist; und
die Funktionskomponente ausgelöst wird, wenn der Sensor (122) von Druck im Mikrometerumfang einer Kraft ausgesetzt ist, die die Auslöseschwelle überschreitet.

3. Schaltersystem des Berührungsbedienungsfelds nach Anspruch 1, wobei die Aufhängungsanordnung (3) zwischen der inneren Stütze (12) und dem Gehäuse (21) montiert ist.

4. Schaltersystem des Berührungsbedienungsfelds nach Anspruch 3, wobei die Aufhängungsanordnung (3) ein elastisches Element (31) und eine elastische Backe (34) umfasst, wobei sich die elastische Backe (34) von einer unteren Oberfläche der inneren Stütze (12) nach unten erstreckt und das elastische Element (31) zwischen der elastischen Backe (34) und dem Gehäuse (21) verbunden ist.

5. Schaltersystem des Berührungsbedienungsfelds nach Anspruch 4, wobei die elastische Backe (34) eine Vielzahl von voneinander beabstandeten Widerhaken (341) umfasst.

6. Schaltersystem des Berührungsbedienungsfelds nach Anspruch 4, wobei die elastische Backe (34) eine umgekehrte Flachrundkopfstruktur (342) umfasst und die Form des elastischen Elements (31) mit der Form der Flachrundkopfstruktur (342) übereinstimmt.

7. Schaltersystem des Berührungsbedienungsfelds nach Anspruch 3, wobei die Aufhängungsanordnung (3) ein erstes elastisches Halteelement (35), ein zweites elastisches Halteelement (36) und ein elastisches Element (31) umfasst, wobei das erste elastische Halteelement (35) mit der inneren Stütze (12) verbunden ist, das zweite elastische Halteelement (36) mit dem Gehäuse (21) verbunden ist und das elastische Element (31) zwischen dem ersten elastischen Halteelement (35) und dem zweiten elastischen Halteelement (36) verbunden ist.

8. Schaltersystem des Berührungsbedienungsfelds nach Anspruch 7, wobei das elastische Element (31) aus Vollgummi oder Hohlgummi hergestellt ist.

9. Lenkrad, **dadurch gekennzeichnet, dass** es das Schaltersystem des Berührungsbedienungsfelds (100) nach einem der Ansprüche 1 bis 8 umfasst.

## Revendications

1. Système de commutation à panneau tactile comprenant un ensemble supérieur (1), un ensemble inférieur (2) et un ensemble de suspension (3) ;
l'ensemble supérieur (1) comprenant un couvercle supérieur (11) et un support interne (12), le couvercle supérieur (11) et le support interne (12) étant reliés de manière fixe l'un à l'autre ;
l'ensemble inférieur (2) comprenant un boîtier (21) et un couvercle inférieur (22), le couvercle supérieur (11) et le boîtier (21) étant reliés de manière mobile l'un à l'autre, le boîtier (21) étant relié de manière fixe au couvercle inférieur (22) ; et
l'ensemble suspension (3) étant relié entre l'ensemble supérieur (1) et l'ensemble inférieur (2), l'ensemble suspension (3) effectuant une course de détente dans une direction Z, et la course de détente étant à l'échelle du micron,
**caractérisé en ce que** l'ensemble inférieur (2) comprend en outre une carte de circuit imprimé (23) située entre le support interne (12) et le couvercle inférieur (22) ; un capteur de pression à l'échelle du micron (122) monté sur la carte de circuit imprimé (23) ; et
une colonne de montage (121) s'étendant vers le bas à partir du support interne (12) et utilisée pour appuyer sur le capteur de pression à l'échelle du micron (122),
et **en ce que** le système de commutation à panneau tactile comprend en outre un prétensionneur (123) monté sur la colonne de montage (121) et en contact avec le capteur de pression à l'échelle du micron (122), le prétensionneur (123) fournissant au capteur de pression à l'échelle du micron (122) une valeur initiale, un seuil de déclenchement étant défini pour le capteur de pression à l'échelle du micron (122).

2. Système de commutation à panneau tactile selon la revendication 1, dans lequel :
un composant fonctionnel du système de commutation à panneau tactile n'est pas déclenché lorsque le capteur de pression à l'échelle du micron (122) est soumis à une force inférieure à la valeur initiale ; et
le composant fonctionnel étant déclenché lorsque le capteur de pression à l'échelle du micron (122) est soumis à une force dépassant le seuil de déclenchement.

3. Système de commutation à panneau tactile selon la revendication 1, dans lequel l'ensemble suspension (3) est monté entre le support interne (12) et le boîtier (21).

4. Système de commutation à panneau tactile selon la revendication 3, dans lequel l'ensemble suspension (3) comprend un élément élastique (31) et une mâchoire élastique (34), la mâchoire élastique (34) s'étendant vers le bas depuis une surface inférieure du support interne (12), et l'élément élastique (31) étant relié entre la mâchoire élastique (34) et le boîtier (21).

5. Système de commutation à panneau tactile selon la revendication 4, dans lequel la mâchoire élastique (34) comprend une pluralité de barbes (341) espacées les unes des autres.

6. Système de commutation à panneau tactile selon la revendication 4, dans lequel la mâchoire élastique (34) comprend une structure de tête de champignon inversée (342), et la forme de l'élément élastique (31) correspond à la forme de la structure de tête de champignon (342).

7. Système de commutation à panneau tactile selon la revendication 3, dans lequel l'ensemble suspension (3) comprend un premier élément de maintien élastique (35), un second élément de maintien élastique (36) et un élément élastique (31), le premier élément de maintien élastique (35) étant relié au support interne (12), le second élément de maintien élastique (36) étant relié au boîtier (21), et l'élément élastique (31) étant relié entre le premier élément de maintien élastique (35) et le second élément de maintien élastique (36).

8. Système de commutation à panneau tactile selon la revendication 7, dans lequel l'élément élastique (31) est constitué de caoutchouc plein ou de caoutchouc creux.

9. Volant, **caractérisé en ce qu'**il comprend le système de commutation à panneau tactile (100) selon l'une quelconque des revendications 1 à 8.
